# EUROPÄISCHE PATENTSCHRIFT

(11) **EP 0 787 421 B1**
(45) Veröffentlichungstag und Bekanntmachung des Hinweises auf die Patenterteilung: **02.09.1998**
(21) Anmeldenummer: 95933332.9
(22) Anmeldetag: 11.10.1995
(51) Int. Cl.: H05K 13/00, H05K 13/04

(54) **RUNDTISCHMASCHINE ZUM BESTÜCKEN VON SUBSTRATEN MIT BAUELEMENTEN**
TURNTABLE MACHINE FOR FITTING SUBSTRATES WITH COMPONENTS
MACHINE A PLATEAU CIRCULAIRE POUR IMPLANTER DES COMPOSANTS SUR DES SUBSTRATS

(30) Priorität: 19.10.1994 DE 4437462
(43) Veröffentlichungstag der Anmeldung: 06.08.1997
(73) Patentinhaber: SIEMENS AKTIENGESELLSCHAFT, 80333 München (DE)
(72) Erfinder: WACKER, Josef, D-82335 Berg (DE)
(86) Internationale Anmeldenummer: DE9501401
(87) Internationale Veröffentlichungsnummer: WO9613143

(56) Entgegenhaltungen:
- EP-A- 0 501 551

## Beschreibung

Bei der automatischen Bestückung von Substraten, insbesondere von Leiterplatten oder Keramiksubstraten, mit SMD-Bauelementen für die Oberflächenmontage (SMD = Surface Mounted Devices), unterscheidet man zwischen dem Pick and Place-Prinzip, dem Chip Shooter-Prinzip und dem Collect and Place-Prinzip.

Beim Pick and Place-Prinzip erfolgt die Bereitstellung der SMD-Bauelemente über ortsfest angeordnete Zuführmodule. Ein an einem x-y-Portalsystem verfahrbar angeordneter Bestückkopf nimmt mit seiner Saugpipette die SMD-Bauelemente aus den Abholpositionen der Zuführmodule auf, transportiert sie zu dem ebenfalls ortsfest angeordneten Substrat und setzt sie aort in den vorgegebenen Bestückpositionen ab. Dadurch sind die nur in Lotpaste oder Kleber eingebetteten SMD-Bauelemente keinen unnötigen Beschleunigungen ausgesetzt. Ein weiterer Vorteil dieses Bestückungsprinzips ist auch die ortsfeste Bauelemente-Bereitstellung, die eine Nachversorgung während des Bestückens erlaubt.

Beim Chip Shooter-Prinzip wird durch einen ortsfesten, horizontal angeordneten Revolverkopf mit einer Vielzahl von Saugpipetten der Abhol- und Bestückvorgang simultan durchgeführt. Die Substratpositionierung erfolgt gleichzeitig mit der Rotation des Revolverkopfes. Die Zuführmodule für die SMD-Bauelemente sind auf einem beweglichen Bauelementetisch angeordnet. Der Vorteil dieses Bestückungsprinzips liegt in der hohen Bestückleistung. Nachteilig ist jedoch, daß eine Bauelementennachversorgung während des Bestückbetriebes nicht möglich ist, und daß bereits bestückte SMD-Bauelemente durch das ständige Beschleunigen und Verzögern der Substrate verrutschen können.

Das Collect and Place-Prinzip vereinigt die Vorteile der flexiblen Pick and Place-Systeme mit jenen der leistungsstarken Shooter. Der Hauptunterschied zu den Pick and Place-Systemen besteht darin, daß anstelle eines Einfachkopfes hier von einem x-y-Portalsystem ein Revolverkopf mit einer Vielzahl von Saugpipetten und mit einer horizontalen Rotationsachse getragen wird. Dieser Revolverkopf nimmt die SMD-Bauelemente nacheinander aus den ortsfest angeordneten Zuführmodulen auf und bestückt sie wegoptimiert auf den ortsfest angeordneten Substraten.

Bestückstationen nach dem Pick and Place-Prinzip können über einen gemeinsamen Substrat-Transport untereinander und mit Auftragsstationen zum Auftragen von Klebstoff oder Lotpaste verkettet werden. Dies trifft auch für Bestückstationen nach dem Collect and Place-Prinzip zu. Da beide Bestücksysteme eine ortsfeste Bauelemente-Bereitstellung und eine ortsfeste Anordnung der Substrate aufweisen, können auch Bestückstationen nach dem Pick and Place-Prinzip und Bestückstationen nach dem Collect and Place-Prinzip untereinander und mit Auftragsstationen zum Auftragen von Klebstoff oder Lotpaste, verkettet werden.

Eine Rundtischmachine zum Bestücken von Substraten mit Bauelementen ist aus EP-A-0 501 551 bekannt.

Der im Anspruch 1 angegebenen Erfindung liegt das Problem zugrunde, mit geringem Aufwand und bei geringem Platzbedarf, eine zuverlässige Verkettung mehrerer SMD-Bestückstationen zu ermöglichen.

Durch die Verkettung mehrerer Bestückstationen in Form einer Rundtischmaschine, ergeben sich ein günstiger Platzbedarf und eine sehr gute Zugänglichkeit der Bestückköpfe und der am Umfang des Rundtisches angeordneten Zuführmodule. Außerdem kann durch die übersichtliche Anordnung der gesamte Bestückvorgang leicht beobachtet werden. Ein weiterer entscheidender Vorteil ist, daß im Gegensatz zu geraden SMD-Fertigungslinien durch den genauen Rundlauf einer Rundtischmaschine eine mechanische Zentrierung und Lageerkennung der Substrate nur einmal vorgenommen werden muß.

Vorteilhafte Ausgestaltungen der Erfindung sind in den Unteransprüchen angegeben.

Ein Ausführungsbeispiel der Erfindung ist in der Zeichnung dargestellt und wird im folgenden näher beschrieben.

Es zeigen
- Figur 1: eine Rundtischmaschine zum Bestücken von Substraten mit Bauelementen in der Draufsicht und
- Figur 2: einen Schnitt gemäß der Linie II-II der Figur 1.

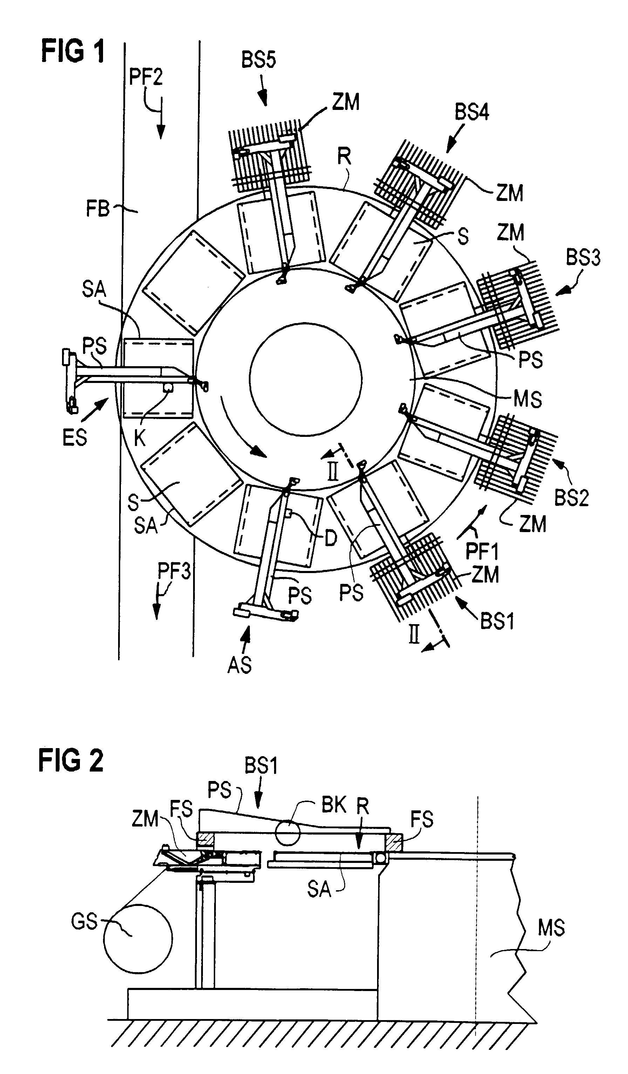

Figur 1 zeigt in stark vereinfachter schematischer Darstellung eine Draufsicht auf eine Rundtischmaschine zum Bestücken von Substraten S mit Bauelementen. Im dargestellten Ausführungsbeispiel handelt es sich bei den Substraten S um Leiterplatten, die mit SMD-Bauelementen bestückt werden. Wesentliches Element der Rundtischmaschine ist ein mit R bezeichneter Rundtisch, der in Richtung des Pfeiles PF1 um eine feststehend angeordnete und vertikal ausgerichtete Mittelsäule MS gedreht werden kann.

Der ringförmige Rundtisch R besitzt insgesamt neun in gleichmäßiger Umfangsteilung angeordnete Substrat-Aufnahmen SA, in welchen die Substrate S von unten her aufgenommen und mechanisch fixiert werden. Die einzelnen Substrate S werden hierzu über ein Förderband FB in Richtung des Pfeiles PF2 zu einer Eingabestation ES transportiert, auf in der Zeichnung nicht näher erkennbare Weise angehoben und in der jeweils sich in der Eingabestation ES befindlichen Substrat-Aufnahme AS fixiert. Die Eingabestation ES umfaßt auch eine CCD-Kamera K, die an einem Portalsystem PS in tangentialer und radialer Richtung des Rundtisches verfahren werden kann. Diese CCD-Kamera K ist Bestandteil eines sogenannten Vision-Systems, mit welchem Referenzmarken oder geeignete Schaltungsstrukturen der Substrate S erfaßt werden. Aus ihrer Lage ermittelt ein Rechner die genaue Position des jeweiligen Substrates S und einen eventuell vorhandenen Substratverzug. Zur späteren Bestückung in unterschiedlichen Stationen werden dann alle Bestückpositionen entsprechend korrigiert. Wahlweise können die Substrate S auch durch Paßstifte mechanisch zentriert werden. Aber auch in diesem Fall können eventuell noch vorhandene Ungenauigkeiten vom Vision-System erfaßt und durch eine entsprechende Korrektur der Bestückpositionen kompensiert werden.

Nach der Übergabe und Aufnahme eines Substrats S in der Eingabestation ES wird dieses Substrat S durch zwei schrittweise Drehungen des Rundtisches R um jeweils 40° zu einer Auftragsstation AS befördert, in welcher Klebstoffpunkte aufgetragen werden, die in Größe und Anzahl auf die jeweiligen SMD-Gehäuseformen abgestimmt sind. Das Auftragen dieser Klebstoffpunkte erfolgt mit einem Dosierkopf D, der an einem Portalsystem PS in tangentialer und radialer Richtung des Rundtisches R verfahren werden kann.

Nach dem Auftragen der Klebstoffpunkte wird das Substrat S durch eine weitere Drehung des Rundtisches R um 40° zu einer ersten Bestückstation BS1 befördert und mit SMD-Bauelementen bestückt. Die Bereitstellung dieser SMD-Bauelemente erfolgt in einer Vielzahl von parallel angeordneten und am Umfang des Rundtisches R in Höhe der ersten Bestückstation BS1 aufgestellten Zuführmodulen ZM. Aus dem in Figur 2 dargestellten Schnitt durch die erste Bestückstation BS1 ist ersichtlich, daß in den hier dargestellten Zuführmodulen ZM gegurtete SMD-Bauelemente bereitgestellt werden, wobei die Gurtspulen mit GS bezeichnet sind.

In der ersten Bestückstation BS1 erfolgt die Bestückung der Substrate S mit einem Bestückkopf BK, der an einem Portalsystem PS in tangentialer und radialer Richtung des Rundtisches R verfahren werden kann. Bei diesem in Figur 2 schematisch angedeuteten Bestückkopf BK handelt es sich um einen nach dem Collect and Place-Prinzip arbeitenden Revolverkopf. Aus Figur 2 ist auch ersichtlich, daß das Portalsystem PS der ersten Bestückstation BS1 auf zwei parallel im Abstand zueinander angeordneten Führungsschienen FS in tangentialer Richtung des Rundtisches R verfahren werden kann. Die äußere Führungsschiene FS ist dabei auf in der Zeichnung nicht näher erkennbare Weise auf dem Fundament abgestützt, während die innere Führungsschiene FS auf der ortsfesten Mittelsäule MS des Rundtisches R ruht. Dies trifft im übrigen auch für alle anderen Portalsystem PS der Rundtischmaschine zu.

Das in der ersten Bestückstation BS1 mit SMD-Bauelementen bestückte Substrat S wird dann in weiteren Drehschritten von jeweils 40° Bestückstationen BS2 bis BS5 zugeführt, die grundsätzlich gleich aufgebaut sind, wie die vorstehend beschriebene erste Bestückstation BS1. Es ist jedoch darauf hinzuweisen, daß einzelne oder gegebenenfalls auch alle Bestückstationen BS1 bis BS5 auch mit Bestückköpfen BK (vergleiche Figur 2) ausgerüstet werden können, die nach dem Pick and Place-Prinzip arbeiten.

Das in der fünften Bestückstation BS5 mit weiteren SMD-Bauelementen bestückte Substrat S, gelangt dann in zwei weiteren Drehschritten von jeweils 40° wieder in die Eingangsstation ES, die im dargestellten Ausführungsbeispiel gleichzeitig auch als Ausgabestation für die mit SMD-Bauelementen bestückten Substrate S dient. Die Substrate S werden dann nach dem Lösen ihrer mechanischen Fixierung über das Förderband FB in Richtung des Pfeiles PF3 beispielsweise einem Infrarot-Ofen zugeführt.

Die Arbeitsweise der Rundtischmaschine wurde vorstehend anhand eines einzelnen Substrates S geschildert, welches die einzelnen Stationen durchläuft. Die Rundtischmaschine ist jedoch so aufgebaut, daß nach jeder schrittweisen Drehung des Rundtisches R in jeder der beschriebenen Stationen jeweils ein Substrat behandelt werden kann.

Die vorstehend anhand der Figuren 1 und 2 beschriebene Rundtischmaschine kann ohne das geschilderte Prinzip zu verlassen, in vielfacher Hinsicht abgewandelt werden. So können neben den beschriebenen Stationen beispielsweise auch andere Stationen am Umfang des Rundtisches R angeordnet werden, wie z.B. Auftragsstationen zum Auftragen von Lotpaste oder Stationen, in welchen Fine-Pitch-ICs gleichzeitig bestückt und durch Bügellöten auf dem Substrat S befestigt werden. Zur Steigerung der Bestückleistung können auch die Ausgabestation und die Station zur Lageerkennung der Substrate S als von der Eingangsstation ES getrennte, separate Stationen ausgebildet werden.

## Patentansprüche

1. Rundtischmaschine zum Bestücken von Substraten (S) mit Bauelementen,
mit
- einem Rundtisch (R), der mehrere in Umfangsrichtung verteilt angeordnete Substrat-Aufnahmen (SA) besitzt,
- einer Eingabestation (ES) zur Übergabe der Substrate (S) an die Substrat-Aufnahmen (SA)
- einer Station zur mechanischen Zentrierung und zur Lageerkennung der Substrate (S) in den Substrat-Aufnahmen (SA),
- mehreren Bestückstationen (BS1 bis BS5), die jeweils ein Portalsystem (PS) mit einem in tangentialer und radialer Richtung des Rundtisches (R) verfahrbaren Bestückkopf (BK) umfassen, und mit
- den Bestückstationen (BS1 bis BS5) zugeordneten und am Umfang des Rundtisches (R) angeordneten Zuführmodulen (ZM) für die Bereitstellung von Bauelementen,
wobei
- der Rundtisch (R) die Substrate (S) den Bestückstationen (BS1 bis BS5) nacheinander zuführt, und wobei
- bei der Lageerkennung der in Substrat-Aufnahmen (SA) fixierten Substrate (S) in den Bestückstationen (BS1 bis BS5) alle Bestückpositionen in Abhängigkeit von der genauen Lage der Substrate (S) korrigiert werden.

2. Rundtischmaschine nach Anspruch 1,
**dadurch gekennzeichnet,**
daß die Substrate (S) mit einem Förderband (FB) der Eingabestation (ES) zugeführt werden.

3. Rundtischmaschine nach Anspruch 1 oder 2,
**dadurch gekennzeichnet,**
daß die Eingabestation (ES) gleichzeitig auch als Ausgabestation für die mit Bauelementen bestückten Substrate (S) dient.

4. Rundtischmaschine nach einem der Ansprüche 1 bis 3,
**dadurch gekennzeichnet**,
daß die Eingabestation (ES) gleichzeitig auch als Station zur mechanischen Zentrierung und Lageerkennung der Substrate (S) in den Substrat-Aufnahmen (SA) dient.

5. Rundtischmaschine nach einem der Ansprüche 1 bis 4,
**dadurch gekennzeichnet,**
daß zur Lageerkennung der Substrate (S) in den Substrat-Aufnahmen (SA) eine an einem Portalsystem (PS) in tangentialer und radialer Richtung des Rundtisches (R) verfahrbare Kamera (K) vorgesehen ist.

6. Rundtischmaschine nach einem der Ansprüche 1 bis 5,
**gekennzeichnet durch** mindestens eine Auftragsstation (AS) zum Auftragen von Klebstoff oder Lotpaste auf die Substrate (S), wobei der Rundtisch (R) die Substrate (S) der Auftragsstation (AS) nacheinander zuführt.

7. Rundtischmaschine nach Anspruch 6,
**dadurch gekennzeichnet**,
daß die Auftragsstation (AS) ein Portalsystem (PS) mit einem in tangentialer und radialer Richtung des Rundtisches (R) verfahrbaren Dosierkopf (D) umfaßt.

## Claims

1. Turntable machine for fitting substrates (S) with components,
having
- a turntable (R) which has a plurality of substrate receptacles (SA) which are arranged distributed in the circumferential direction,
- an input station (ES) for transferring the substrates (S) to the substrate receptacles (SA)
- a station for mechanical centring and for orientation identification of the substrates (S) in the substrate receptacles (SA),
- a plurality of fitting stations (BS1 to BS5) which each comprise a gantry system (PS) having a fitting head (BK) which can be moved in the tangential and radial directions of the turntable (R), and having
- feed modules (ZM), which are assigned to the fitting stations (BS1 to BS5) and are arranged on the circumference of the turntable (R), for providing components,
- the turntable (R) feeding the substrates (S) to the fitting stations (BS1 to BS5) successively, and
- on orientation identification of the substrates (S) which are fixed in substrate receptacles (SA), in the fitting stations (BS1 to BS5), all the fitting positions are corrected as a function of the precise orientation of the substrates (S)

2. Turntable machine according to Claim 1,
characterized
in that the substrates (S) are fed to the input station (ES) by a conveyor belt (FB).

3. Turntable machine according to Claim 1 or 2,
characterized
in that the input station (ES) is at the same time also used as the output station for the substrates (S) which have been fitted with components.

4. Turntable machine according to one of Claims 1 to 3,
characterized
in that the input station (ES) is at the same time also used as the station for mechanical centring and orientation identification of the substrates (S) in the substrate receptacles (SA).

5. Turntable machine according to one of Claims 1 to 4,
characterized
in that a camera (K), which can be moved on a gantry system (PS) in the tangential and radial directions of the turntable (R), is provided in order to identify the orientation of the substrates (S) in the substrate receptacles (SA).

6. Turntable machine according to one of Claims 1 to 5,
characterized by at least one application station (AS) for applying adhesive or solder paste to the substrates (S) , the turntable (R) feeding substrates (S) to the application station (AS) successively.

7. Turntable machine according to Claim 6,
characterized
in that the application station (AS) comprises a gantry system (PS) having a metering head (D) which can be moved in the tangential and radial directions of the turntable (R).

## Revendications

1. Machine à plateau circulaire pour implanter des composants sur des substrats (S), comportant
- un plateau (R) circulaire qui comporte plusieurs empreintes (SA) pour substrats ménagées de manière répartie dans la direction périphérique,
- un poste (ES) d'entrée pour la transmission des substrats (S) aux empreintes (SA) pour substrats,
- un poste pour le centrage mécanique et pour la reconnaissance de position des substrats (S) dans les empreintes (SA) pour substrats,
- plusieurs postes (BS1 à BS5) d'implantation qui comprennent chacun un système (PS) de portique à tête (BK) d'implantation pouvant être déplacée dans la direction tangentielle et dans la direction radiale du plateau (R) circulaire, et comportant
- des modules (ZM) d'alimentation pour la mise à disposition de composants qui sont associés aux postes (BS1 à BS5) d'implantation et qui sont montés sur le pourtour du plateau (R) circulaire,
- le plateau (R) circulaire envoyant les uns après les autres les substrats (S) aux postes (BS1 à BS5) d'implantation, et
- toutes les positions d'implantation dans les postes (BS1 à BS5) d'implantation étant corrigées en fonction de la position exacte des substrats (S) lors de la reconnaissance de position des substrats (S) immobilisés dans des empreintes (SA) pour substrats.

2. Machine à plateau circulaire suivant la revendication 1,
caractérisée
en ce que les substrats (S) sont envoyés au poste (ES) d'entrée par une bande (FB) convoyeuse.

3. Machine à plateau circulaire suivant la revendications 1 ou 2,
caractérisée
en ce que le poste (ES) d'entrée sert en même temps aussi de poste de sortie aux substrats (S) sur lesquels des composants ont été implantés.

4. Machine à plateau circulaire suivant l'une des revendications 1 à 3,
caractérisée
en ce que le poste (ES) d'entrée sert en même temps aussi de poste pour le centrage mécanique et la reconnaissance de position des substrats (S) dans les empreintes (SA) pour substrats.

5. Machine à plateau circulaire suivant l'une des revendications 1 à 4,
caractérisée
en ce qu'il est prévu, pour la reconnaissance de position des substrats (S) dans les empreintes (SA) pour substrats, une caméra (K) pouvant être déplacée sur un système (PS) de portique dans la direction tangentielle et dans la direction radiale du plateau (R) circulaire.

6. Machine à plateau circulaire suivant l'une des revendications 1 à 5,
caractérisée par au moins un poste (AS) de dépôt pour déposer de la colle ou de la pâte à braser sur les substrats (S), le plateau (R) circulaire envoyant les substrats (S) les uns après les autres au poste (AS) de dépôt.

7. Machine à plateau circulaire suivant la revendication 6,
caractérisée
en ce que le poste (AS) de dépôt comporte un système (PS) de portique à tête (D) doseuse pouvant être déplacée dans la direction tangentielle et dans la direction radiale du plateau (R) circulaire.
